Europäisches Patentamt

European Patent Office

Office européen des brevets

(11) Veröffentlichungsnummer: **0 335 155**
**A2**

# EUROPÄISCHE PATENTANMELDUNG

(21) Anmeldenummer: **89104335.8**

(22) Anmeldetag: **11.03.89**

(51) Int. Cl.⁴: **G01N 21/89**

(30) Priorität: 26.03.88 DE 3810349

(43) Veröffentlichungstag der Anmeldung:
04.10.89 Patentblatt 89/40

(84) Benannte Vertragsstaaten:
CH DE FR GB IT LI

(71) Anmelder: **Agfa-Gevaert AG**

**D-5090 Leverkusen 1(DE)**

(72) Erfinder: **Kreuzer, Erwin, Dipl.-Ing.**
**Goethering 56**
**D-8018 Grafing(DE)**
Erfinder: **Zierl, Richard, Dr.**
**Flurstrasse 21**
**D-8031 Eichenau(DE)**

(54) **Verfahren sowie Anordnung zur Darstellung von Oberflächenfehlern an Aufzeichnungsträgern.**

(57) Beschrieben wird ein vollautomatisch ablaufendes Verfahren zur Registrierung und On-line-Betrachtung von Oberflächenfehlern beispielsweise Drop-outs an Magnetbändern, bestehend aus einer optischen Registrierung des Oberflächenfehlers, einer Recheneinheit zur Bestimmung der Position des Oberflächenfehlers, zur Steuerung der Betrachtungsvorrichtung, welche auf einem Schlitten montiert ist, an die betreffende Fehlerstelle, worauf der Fehler an dem bewegten Magnetband mittels Ultrakurzzeitblitz erfolgt, worauf das elektronische Bild auf einem Festspeicher zwischengespeichert und anschließend auf einem Videodisplay dargestellt oder als Hardcopy ausgedruckt wird.

*FIG. 1*

## Verfahren sowie Anordnung zur Darstellung von Oberflächenfehlern an Aufzeichnungsträgern

Die Erfindung betrifft ein automatisiertes Verfahren sowie eine entsprechende Anordnung zur Lokalisierung sowie zur Betrachtung von Oberflächenfehlern an bewegten bandförmigen Aufzeichnungsträgern, insbesondere Magnetbändern.

Eine derartige Anordnung ist beispielsweise aus der EP 0 183 481 bekannt. Sie besteht aus einem kommerziellen Videorekorder, einem käuflichen Drop-out-Meßgerät, einem Computer zur Berechnung der Ortskoordinaten des registrierten Fehlers und einem Mikroskop oder einem Profilometer, die an die Stelle des registrierten Fehlers positioniert werden, zur Betrachtung des Fehlerbildes. Diese Anordnung weist folgende Nachteile auf:
- Die Registriergeschwindigkeit ist, wie bei Videorekordern üblich, relativ klein.
- Infolge Umlenkungen des Aufzeichnungsträgers über Rollen, Wellen und so weiter, nach dem Registriervorgang kann der Fehler verschwinden oder das Fehlerbild kann sich ändern.
- Zur Betrachtung des Fehlers muß der Aufzeichnungsträger gestoppt werden.

Auf diese Weise können nach den Angaben dieser Publikation maximal 40 Drop-outs in 15 Minuten geprüft werden. Die US 4 656 663 beschreibt eine Anordnung zur Bestimmung von Oberflächeneigenschaften von Schichtträgern durch Aufdampfen metallischer Schichten und Betrachten der Schicht mittels Mikroskop im reflektierten Licht. Diese Methode ist extrem aufwendig und für Routineuntersuchungen nicht geeignet. In der EP 0 087 235 wird die zu untersuchende Schicht mit Hilfe eines flying-spot-Lichtstrahls, welcher elektroakustisch abgelenkt wird, abgetastet. Diese Anordnung ist aufwendig und sie dürfte zur Betrachtung von Einzelfehlern kaum geeignet sein.

Bei der Herstellung und der Prüfung von Aufzeichnungsträgern, beispielsweise Magnetbändern, besteht insbesondere die Aufgabe

a) On-line automatisch die Registrierung und Betrachtung von Oberflächenfehlern an bewegten Aufzeichnungsträgern durchzuführen.

b) Es muß gewährleistet sein, daß zwischen Registrierung und Betrachtung das Fehlerbild ungeändert bleibt.

c) Zur Betrachtung darf der Aufzeichnungsträger nicht angehalten werden.

d) Die Auflösung muß so groß sein, daß der Fehler identifiziert werden kann (Kratzer, aufgequetschte Teilchen, Schichtaussetzer).

e) Das Fehlerbild soll festgehalten werden.

Die Aufgabe wurde erfindungsgemäß gelöst mit einem Verfahren sowie einer Anordnung zur Darstellung von Oberflächenfehlern an Aufzeichnungsträgern mit den im kennzeichnenden Teil des Anspruchs 1 genannten Merkmalen. Weitere Einzelheiten der Erfindung gehen aus den Unteransprüchen, der Beschreibung und den Zeichnungen hervor. Nachstehend wird die Erfindung anhand der Zeichnungen näher erläutert und zwar stellt

Figur 1 eine schematische Schnittzeichnung

Figur 2 eine schematische Draufsicht auf die erfindungsgemäße Vorrichtung

dar.

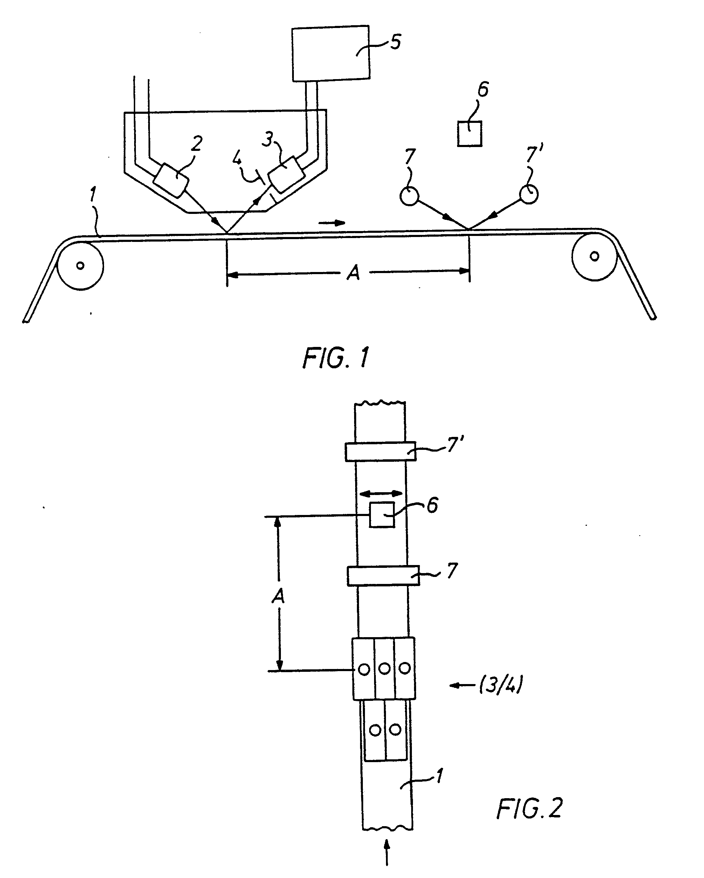

Wie in Figur 1 dargestellt, beleuchtet eine Lichtquelle (2) beispielsweise eine Leuchtröhre oder mehrere senkrecht zur Laufrichtung des Aufzeichnungsträgers angeordnete LED-Zellen den in Pfeilrichtung laufenden Aufzeichnungsträger (1). Das reflektierte Licht wird vorzugsweise von mehreren Fotoempfängern (3) registriert, vor die Blenden (4) zur Begrenzung des aufgenommenen Meßfeldes angebracht sein können. Die Fotoempfänger (3) sind wie die Lichtquelle senkrecht zur Laufrichtung des Schichtträgers entweder nebeneinander oder wie in Figur 2 dargestellt versetzt parallel zueinander angeordnet, um eine möglichst große Registrierdichte zu erreichen. Die Fotoempfänger geben ihr Signal an eine Auswerteelektronik (5) ab, welche die von Schichtfehlern herrührenden Signaländerungen registriert und verarbeitet. Ferner befindet sich in Laufrichtung des Aufzeichnungsträgers im Abstand A eine Kamera, beispielsweise eine Sofortbild- oder elektronische Kamera (6), welche, wie in Figur 2 angedeutet, auf einen Schlitten montiert ist und aufgrund des in der Auswerteeinheit (5) verarbeiteten Signals quer zur Laufrichtung des Aufzeichnungsträgers an die betreffende Fehlerstelle gesteuert wird. Gleichzeitig errechnet die Auswerteeinheit aufgrund der Laufzeit des Aufzeichnungsträgers, bedingt durch den Abstand A und die Geschwindigkeit den richtigen Aufnahmezeitpunkt, an dem die Fehlerstelle die Position der Aufnahmekamera erreicht hat.

Um eine hohe Auflösung zu erreichen, wird das Aufnahmefeld durch ein oder mehrere neben der Kamera (6) angebrachte Lichtquellen (7, 7′), vorzugsweise Ultrakurzzeitblitz-Röhren, beleuchtet. Der Abstand A muß natürlich mindestens so groß bemessen sein, daß die Laufzeit des Aufzeichnungsträgers von der Registrierstelle bis zur Aufnahmeposition größer ist als die Einstellzeit der Kamera. Die Aufnahmekamera kann, wie bereits erwähnt, eine Sofortbild-Kamera oder bevorzugt eine elektronische Kamera mit einem CCD-Bildpunktarray sein, bei der die Bildinformation beispielsweise auf einem Festspeicher zwischengespeichert und nachfolgend auf einem Videodisplay und/oder einer Hardcopy beispielsweise einem Thermodrucker oder elektrostatischem Drucker dargestellt wird. Gegebenenfalls ist eine langfristige Speicherung auf einer Festplatte möglich.

Auf diese Weise ist eine eindeutige Zuordnung des registrierten Fehlers zu der Aufnahme des Fehlerbildes gegeben, was eine rationelle Prüfung ohne weitere zusätzliche Maßnahmen und vor allem ohne Unterbrechung des Fabrikationsablaufes gewährleistet. Die maximale Anzahl meßbarer Fehler ist gegeben durch die Einstellzeit der Kamera und die Blitzfolgedauer.

Beispiel 1

Ein 60 cm breiter magnetischer Aufzeichnungsträger, bestehend aus einer auf einen Polyethylenterephthalat-Schichtträger aufgezogenen 6 μm dicken magnetischen Schicht, fährt mit 3 m/Sekunde Geschwindigkeit aus der Gieß- und Trockeneinrichtung kommend in die erfindungsgemäße Anordnung ein. Quer zur Laufrichtung ist eine röhrenförmige Lichtquelle angeordnet, die unter einem Winkel von zirka 60° zur Schichtoberfläche diese beleuchtet und der unter dem Reflexionswinkel angebrachte Fotoempfänger, welche im 1/2-Zoll-Abstand (1,25 cm) angeordnet sind gegenüberstehen, die das reflektierte Licht auffangen. Das aus den Fotoempfängern kommende Stromsignal wird, analog wie in den Anmeldungen P 37 28 704 und P 37 28 705 der Anmelderin erläutert, in ein Spannungssignal umgewandelt, welches verstärkt und ausgewertet wird, wie in den erwähnten Anmeldungen geschildert. Dabei können leichte Abstandsänderungen vom Schichtträger und Fotoempfänger sowie Helligkeitsänderungen der Lichtquelle durch optische beziehungsweise elektronische Maßnahmen kompensiert werden.

In 300 cm Abstand von der Registriereinrichtung befindet sich senkrecht über der Magnetschichtbahn eine elektronische Kamera, die durch die geschilderte Registriereinheit quer zur Bandlaufrichtung an die zu betrachtende Fehlerstelle gesteuert wird. Sobald sich die Kamera über der Fehlerstelle befindet, wobei der richtige Zeitpunkt mittels der erwähnten Recheneinheit bestimmt wird, wird eine neben der Kamera befindliche Kurzbogen-Blitzröhre (Heimann, Typ DGS 8907), Impulshöhe 80 Ws, Belichtungszeit 10 μs, gezündet. Der Abbildungsmaßstab ist so gewählt, daß die abgetastete 1/2-Zoll-Breite der Höhe des Kleinbildformats 24 x 36 mm entspricht. Auf diese Weise lassen sich Fehlerstrukturen ab 30 μm Ausdehnung darstellen.

Beispiel 2

Ein auf 1/2-Zoll-Breite (1,25 cm) geschnittenes Magnet-Videoband wird mit einer Geschwindigkeit von 1,5 m/Sekunde durch eine erfindungsgemäße Vorrichtung durchgeführt. Diese besteht aus mehreren gemäß Figur 2 versetzt angeordneten Laserstrahlern, bevorzugt Kupferdampflasern mit 20 ns Pulsdauer und 40 W Leistung und im Reflexionswinkel senkrecht zur Laufrichtung angeordneten 0,5 mm jeweils voneinander entfernten Fotoempfängern, die das reflektierte Licht auffangen. 150 cm nach dieser Registriereinrichtung befindet sich eine auf einem Schlitten für die Quereinstellung angeordnete elektronische Kamera. Diese wird entsprechend der in Beispiel 1 genannten Registrierungsart auf diesen Bereich eingestellt, auf dem ein Fehler angezeigt wurde, worauf nach der von der Recheneinheit bestimmten Zeit Blitzlampe oder Laserblitz ausgelöst und die Fehlerstelle aufgenommen wird. Diesmal sind Abbildungsmaßstab und Blitzzeit so dimensioniert, daß Fehler mit einer Größe von 1 bis 2 μm festgehalten werden können.

Um ausreichende Bewegungsschärfen zu erreichen, kann es notwendig sein, die Kamera auf die Geschwindigkeit des Aufzeichnungsträgers zu beschleunigen und während der Aufnahme eine Strecke synchron zum Aufzeichnungsträger mitlaufen zu lassen.

Ansprüche

1. Vollautomatisch ablaufendes Verfahren sowie Anordnung zur Registrierung und On-line Betrachtung von Oberflächenfehlern an bandförmigen bewegten Aufzeichnungsträgern, bestehend aus einer optischen Registrierung der Oberfläche des Aufzeichnungsträgers, einer Recheneinheit zur Bestimmung eines aufgefundenen Oberflächenfehlers und zur Steuerung der Betrachtungsvorrichtung, welche im Abstand zur Registriereinheit in Laufrichtung des Aufzeichnungsträgers angeordnet ist, an die Fehlerstelle, dadurch gekennzeichnet, daß als Betrachtungsvorrichtung eine Sofortbildkamera oder eine elektronische Kamera mit einem CCD-Array verwendet wird, und daß die Beleuchtung der Fehlerstelle mittels Ultrakurzzeitblitz oder eines Lasers erfolgt, deren Auslösezeitpunkt durch die Recheneinheit gesteuert wird.

2. Verfahren und Vorrichtung nach Anspruch 1, dadurch gekennzeichnet, daß zur Aufnahme des Oberflächenfehlers die Kamera kurzzeitig auf die Laufgeschwindigkeit des Aufzeichnungsträgers beschleunigt wird und die Geschwindigkeit während der Aufnahme aufrechterhalten wird.

3. Verfahren und Vorrichtung nach den Ansprüchen 1 oder 2, dadurch gekennzeichnet, daß das von der elektronischen Kamera registrierte Bild auf einem Festspeicher zwischengespeichert und anschließend auf einem Video-Display dargestellt wird.

4. Verfahren und Vorrichtung nach Anspruch 1 oder 2, dadurch gekennzeichnet, daß das von der elektronischen Kamera registrierte Bild nach Zwischenspeicherung als Hardcopy ausgedruckt wird.

*FIG. 1*

*FIG.2*

A-G 5344